Europäisches Patentamt

European Patent Office

Office européen des brevets

(19)

(11) Publication number: 0 394 977
A2

## (12) EUROPEAN PATENT APPLICATION

(21) Application number: 90107797.4

(22) Date of filing: 25.04.90

(51) Int. Cl.5: H05K 3/12, H05K 3/18, H05K 3/46

The title of the invention has been amended (Guidelines for Examination in the EPO, A-III, 7.3).

(30) Priority: 27.04.89 GB 8909729

(43) Date of publication of application:
31.10.90 Bulletin 90/44

(84) Designated Contracting States:
CH DE ES FR IT LI NL

(71) Applicant: AMP/AKZO J.V., Inc.
322, L.I.E., South Service Road
Melville, NY 11747(US)

(72) Inventor: Firmstone, Michael George
Manor Park
Runcorn, Cheshire(GB)
Inventor: Stephens, Robert Alan
Manor Park
Runcorn, Cheshire(GB)

(74) Representative: Königseder-Egerer, Claudia D.
Zugspitzstrasse 65
D-8104 Grainau(DE)

(54) Fireable compositions.

(57) A process for producing a metal seed layer on a substrate for a multi- or single-layer circuit in which a firable dielectric composition and a seed-layer composition are applied in turn to a substrate and are co-fired, i.e., without firing the dielectric composition before applying the seed-layer composition to it.

Fig.6.

EP 0 394 977 A2

## COMPOSITIONS

The present invention relates to a process for the production of seed layers which promote the adhesion of metal circuit elements to substrates in single- and multi-layer circuits.

It is known to use a seed layer of substantially one inert metal to promote the adhesion of metal elements of a high density electrical circuit to a substrate, for example that of copper tracks to a ceramic substrate. Such layers may consist of gold containing traces (<2% w/w) of metals such as bismuth and rhodium, and minute traces (≪0.1% w/w) of metals such platinum and silver. It is also known to produce such seed layers by applying a fluid composition comprising an organometallic compound of the desired seed layer metal, organic compounds of the trace metals, a resin derivative and a fluid vehicle to a substrate in a desired pattern, eg by screen printing, and then firing the coated substrate to thermally decompose the composition and produce a metal seed layer in a corresponding pattern adhering to the substrate.

It is further known to produce a substrate layer for bearing circuit components in a single- or multi-layer circuit by applying a firable fluid composition comprising a dielectric to a surface of a first substrate, and to fire the first substrate when so coated. It is known to apply a layer of metal circuit elements to a (second) substrate layer so produced using a seed layer to promote adhesion of the elements to the substrate. In a multilayer circuit the first substrate will bear a layer of circuit components, and the second substrate layer will be applied to cover at least some of the components.

One disadvantage of such conventional seed layers so applied to such a (second) substrate is that the adhesion between the layer and the substrate tends to weaken drastically, well within the operational lifetime of the circuit after use at typical moderately elevated operating temperatures. This effect may be so pronounced that a track and its seed layer may easily be peeled from as a cohesive whole.

Surprisingly, we have now found that it is possible to provide a process for producing such seed layers which confers particularly good physical properties on a seed layer upon such a substrate. In particular, such a process is capable of producing a seed layer which does not suffer from the above disadvantageous weakening to the same extent.

Accordingly, in a first aspect the present invention provides a process for producing a metal seed layer on a substrate for an electrical single- or multilayer circuits, which comprises

a) applying a layer of a firable fluid composition comprising a dielectric to a surface of a first substrate, and

b) applying to the layer on the surface of the first substrate a firable fluid composition comprising an organometallic compound of a desired seed layer metal, characterised by then firing the product coated first substrate to simultaneously fire and fuse the dielectric comprising composition and the organometallic comprising composition forming a second substrate layer on the first substrate and a metal seed layer on the second substrate layer.

In this process, when used for the production of a multilayer circuit, the first substrate will bear a layer of circuit components, and the second substrate layer will be applied to cover at least some of the components.

The final firing step both burns out organics in and fuses the dielectric composition to produce the second substrate layer and burns out organics in and thermally decomposes the seed layer composition to produce a metal seed layer adhering to that substrate. Conventionally, of course a dielectric layer is fired between steps a) and b) to fuse and produce a (second) substrate for the seed layer.

In the present process, vehicle is often evaporated from the dieletric composition on the first substrate between steps a) and b) so that it is no longer fluid (eg so that it is at least touch-dry) before the seed layer composition is applied. However, it is never fired to burn out organics or to fuse the dielectric.

In a second aspect the present invention provides a single- or multi-layer circuit comprising a seed layer on a substrate layer, where both layers have been produced by the process of the first aspect of the invention.

The (second) substrate layer and seed layer produced in the process of the present invention by co-firing a substrate composition and a seed layer composition as referred to above appear to bind well to each other and appear to do so at least in part by the diffusion of colloidal seed layer metal or its oxide into the substrate layer surface.

Accordingly, in a third aspect the present invention provides a single- or multi-layer circuit comprising a seed layer on a substrate layer, characterised in that the substrate layer adjacent to the seed layer contains a colloidal dispersion of a seed layer metal or its oxide.

The process of the first aspect of the invention and the product of the second and third aspects will now be described with reference to the attached drawings, in which:

Figures 1 to 6 are sections through a multi-layer circuit comprising the seed layer, at various stages of production: and

Figure 7 is a section through a modified circuit of this type.

It will be appreciated that although the following description is of the production of a layer in a multilayer circuit, the techniques described are equally applicable to the production of a single-layer cirucit.

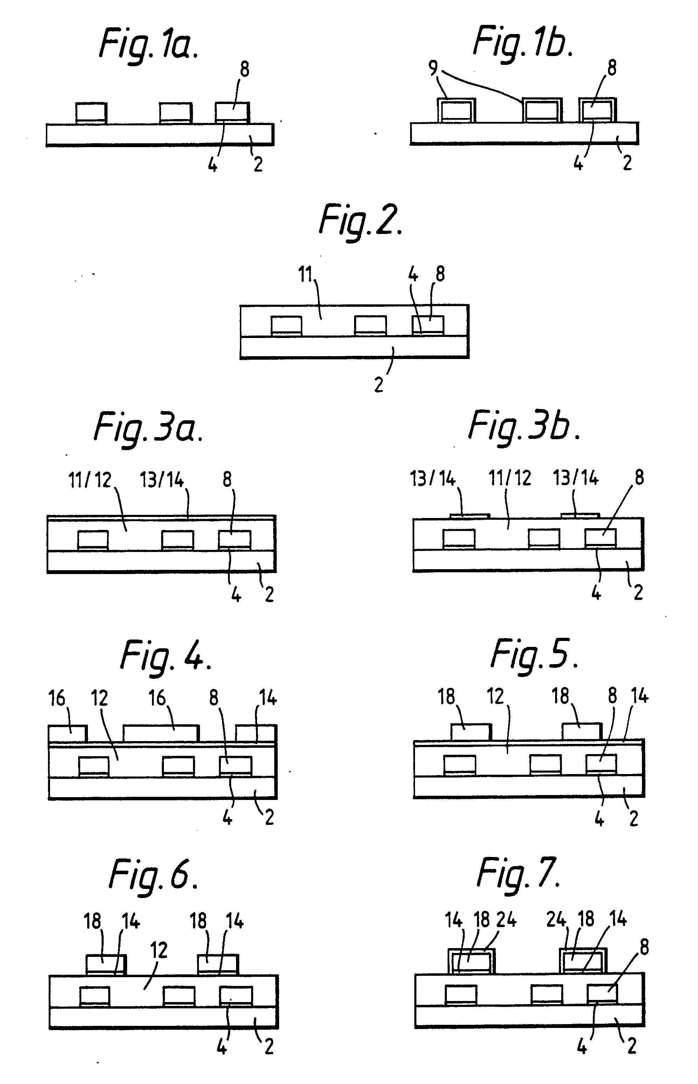

As shown in Figure 1a, the first substrate layer 2, onto which a second (dielectric) substrate layer 12 and a gold seed layer 14 are to be introduced, comprises a substrate 2, typically of a high temperature and/or refractory material as described further hereinafter eg 96% pure alumina in the form of a flat rectangular plate, optionally with through-holes or cut-outs, eg a 100mm x 100mm square plate, 0.5 to 1mm thick. A conductor pattern 8 of a suitable metal (as described further hereinafter), preferably copper or gold and typically in tracks 10 to 35 micron wide and 3 to 75 micron thick, is bonded to a surface of the substrate 2 by a seed layer 4, of an inert metal, typically gold, often at a loading of 0.1 to 2 mg/cm$^2$, in a pattern corresponding to that of the conductor tracks.

In one modification (not shown), the substrate 2 may bearcircuits on both faces with through hole connections. The tracks 8 and/or components may also or alternatively be provided with via posts 7 (not shown) which will protrude away from the substrate surface 2 through the final second substrate layer 12 to form connections to the first circuit layer and/or between the first circuit layer and a second to be formed over it.

In one modification of the first substrate, shown in Figure 1b, the copper pattern 8 is coated at least on its upper surface with a film 9.

The film 9 is of a metal which will inhibit the diffusion of oxygen into, and oxidation of, the conductor pattern 8 during any firing in the present process which may (typically) be carried out in air. This film 9 may be nickel, palladium, gold, silver, chromium, rhodium, or any alloy thereof. The film 9 is particularly useful ins areas where the (oxidisable) copper is exposed to air, eg in through holes between adjacent layers in the multi-layer circuit.

In yet a further modification (not shown), the film 9 is coated with a thin film of copper to be oxidised and act as an adhesion layer between the film 9 and the second (fired dielectric substrate) 12 applied in the present process.

As shown in Figure 2, a layer 10 of a fluid precursor composition of a second substrate layer 12 is introduced onto the surface of the first substrate 2 by a conventional method.

Conventional application methods include printing, coating or other transfer methods, such as spraying, screen printing, curtain or roller coating, or decal or transfer application.

The composition is often applied as an essentially continuous layer 10 covering at least a substantial part of the first substrate 2 throughout. Any via posts 7 (referred to above) protrude through the layer 10.

The dielectric composition layer 10 may also be laid down with a pattern of through holes or vias. In the final (second substrate) dielectric layer 12, such through holes or vias will provide access to and/or passageways for electrical connections to the conductors 8 (or other components, not shown) of the first circuit layer on the first substrate 2, or between the first circuit layer and the (second) one to be formed on it.

The second substrate precursor composition is typically a suspension of particles of an air-firing dielectric, eg a glass or glass-ceramic having a fusion temperature of 400 to 1000° C, in a fluid but fairly viscous vehicle composition. The vehicle composition typically comprises a viscosifier in a liquid vehicle. (The dielectric composition is described in further detail hereinafter).

The coated substrate 2 is then heated conventionally to a temperature well below the dielectric fusion temperature and that which burns out organics in the dielectric composition, eg to 140 to 200° C, to evaporate the vehicle in the composition layer 10 to give a product which has a dry dielectric layer 11 on the substrate 2, typically comprising the dielectric particles dispersed in the viscosifier as a binder.

Deposition of the fluid precursor composition sufficient to give a dielectric layer 11 of a depth of 15 to 60 micron is suitable for most purposes. A suitable depth of precursor composition layer 10 to give this depth of dielectric layer 11 may readily be determined by the skilled man by routine trial and without undue experimentation.

Alternatively, the dielectric composition may be laid down in a plurality of layers, eg two layers. In this case, for example, a first layer thick enough to give a dielectric layer 15 to 40 micron thick may be applied, and fired conventionally to give a fused dielectric layer. A second (generally coextensive) layer may then be applied to the first layer and dried as described above to give a dry layer 2 to 20 micron thick.

Again, a suitable depth of this second precursor composition layer to give this depth of dried but unfired dielectric layer may readily be determined by the skilled man by routine trial and without undue

3

experimentation.

As shown in Figures 3a and b, a seed layer 14, typically of gold, is introduced and bonded onto the surface of the dielectric layer 11 (which may have through-holes or be perforated by the via posts 7 mentioned above, if it is desired to provide inter-layer connection in this way).

The seed layer 14 is introduced by deposition onto the dried dielectric layer 11 of a fluid precursor composition of the seed layer 14. A layer 13 of the composition on the dielectric layer 11 is formed by a conventional printing, coating or other transfer method.

The seed layer precursor composition typically comprises an organometallic compound of the desired seed layer metal having a decomposition temperature of 150 to 350°C, in a fluid but fairly viscous vehicle composition. The vehicle composition typically comprises a resin in a liquid vehicle. (The seed layer composition is described in further detail hereinafter).

Deposition of the fluid precursor composition sufficient to give a final metal seed layer 14 at a loading of 0.2 to 2mg/cm² is suitable for most purposes. A suitable loading of precursor composition layer 13, generally within the range of 0.4 to 30 mg/cm², to give this depth of seed layer 14 may readily be determined by the skilled man by routine trial and without undue experimentation.

In a first embodiment, shown in Figure 3a, the precursor is applied as a continuous layer 13 covering the dielectric layer 11 throughout, eg by screen printing, or curtain or roller coating or transfer application.

This layer will be subsequently removed in part after the conductor tracks 18 are applied to it to correspond to the desired final circuit conductor track pattern 18.

In a second embodiment, shown in Figure 3b, a gold seed layer 14 is laid down generally corresponding to the final conductor track pattern.

In one variant the precursor is applied in any desired pattern 13, eg by screen printing or decal or transfer application, usually corresponding to the desired final circuit.

In a second variant the precursor is applied as a continuous layer 13 covering the dry dielectric 11 throughout as in Figure 3a, eg by screen printing, spraying, curtain or roller coating, or transfer application, and converted to a continuous sheet gold layer 14, This layer 14 is subsequently removed in part before the conductor tracks 18 are applied to it to produce the patterned seed layer 14 corresponding to the desired final circuit conductor track pattern 18.

These two embodiments are of course two extreme cases, the process may often be a combination of features of both, ie the seed layer precursor 13 will be laid down and the seed layer produced in a pattern corresponding to the final track pattern of that circuit layer with extra areas to provide electrical continuity over the whole pattern.

Such continuity may be needed for convenience in the subsequent plating of the tracks onto the seed layer.

Since they will not be needed in the final circuit layer, the surplus areas will be removed to give a seed layer pattern corresponding essentially to the circuit conductor track pattern 18.

In all the foregoing embodiments and variants, any via may as desired be plugged with the seed layer precursor composition or a via fill to form a connection through to the first circuit layer on the first substrate 2 which is integral with the final seed layer 14.

The coated substrate 2 is then fired conventionally at 400 to 1000°C so that

a) the binder in the dielectric layer 11 burns off and the dielectric fuses to form a dense, insulating and non-porous dielectric layer (second substrate) 12, suitably of a depth of 15 to 60 micron for most purposes, and

b) the organometallic compound in the precursor seed layer 13 decomposes to release the appropriate seed layer metal, the resin (optionally cures and) burns off, and the metal fuses to form a solid, cohesive metal seed layer 14, suitable at 0.1 to 2mg/cm² for most purposes.

The firing step affects the dielectric - seed layer interface, in that the metal component of the seed layer or its oxide (in air-firing) appears to diffuse into the dielectric. The depth to which this occurs varies inter alia with the particular components, the firing temperature and the glassiness of the dielectric, but it is believed that this diffusion tends to improve seed layer - dielectric adhesion.

It is surprising with this diffusion and in some cases oxidation that the relatively thin seed layer remains electrically continuous and is not apparently penetrated or enveloped by the fusing dielectric, and thus surprisingly provides a practicable substrate for electroplating.

The firing is preferably carried out at towards 900°C, optionally first applying a dwell time at about 500°C.

Some compositions may produce a seed layer at lower temperatures (eg in the range of 500 to 700°C), and may be suitable for use on lower melting or softening (first or second) substrates. Suitable temperatures and heating profiles for such lower-firing compositions will be apparent to the skilled man.

4

An advantage of the present process is that it enables firing at lower temperatures for shorter times than are conventionally required for the same substrate-dielectric-seed layer systems, with improved adhesion between the latter two components.

In all cases the coating and firing steps may be repeated as often as desired.

In the second variant of the second (Figure 3b) embodiment, the sheet gold seed layer 14 is first coated with light-hardening or-solubilising electrical resist 15 (not shown). The resist 15 is exposed to a light pattern corresponding respectively to of a desired conductor pattern or a negative of the pattern.

The unhardened or solubilised parts of the resists 15 are then selectively dissolved with a conventional fluid (see also the description hereinafter of Figure 4) to expose the seed layer 14 underneath selectively, defined by a resist corresponding to the desired pattern.

The seed layer 14 surface uncovered by the resist 15 is then attacked with an appropriate solvent for the seed layer metal, such as aromatic sulphonate/cyanide solution eg Superstrip 100 (Lea Ronal), potassium iodide/iodine solution, or Entreat 100(Engelhard).

The solvent removes all of the continuous seed layer 14 not covered by the resist 15, resulting in essentially the same product as in the first variant of the second embodiment.

In both embodiments, referring to Figure 6, a conductor pattern 18 of suitable metal (as mentioned hereinbefore), preferably copper or gold, is then formed on the seed layer.

The conductor pattern 18 may conveniently be formed in situ, for example by plating a pattern seed layer 14 shown in Figure 3a, or by masking and plating of the sheet seed layer 14 shown in Figure 3b, although the ex situ formation of a solid pattern 18 and its application to the seed layer 14 is not excluded.

In in-situ formation of the conductor pattern 18 in both present embodiments, the seed layer 14 is then electroplated with solid copper to a thickness and width at all points well in excess of the thickness of the seed layer 14, for example 3 to 75 micron, in particular 5 to 20 micron, and in the desired conductor pattern 18.

Figure 4 shows the first step in the plating part of the process applied to the Figure 3a embodiment.

In this embodiment the sheet gold seed layer 14 is first coated with light-hardening or -solubilising electrical resist 16 generally to a thickness in the range of from 3 to 75 micron, but in any event usually at least as thick as the intended thickness of the subsequently applied metal (eg copper) tracks.

The resist 16 is exposed to a light pattern corresponding respectively to a negative of a desired conductor pattern or the pattern itself. The unhardened or solubilised parts of the resist 16 are then selectively dissolved with a conventional fluid to expose the seed layer 14 underneath selectively, defined by a resist corresponding to a negative of the desired pattern.

After such partial removal of the resist 16 the product is conventionally electroplated or electrolessly plated.

In the first (Figure 3a) present embodiment, the conductor pattern 18 may also be applied to the sheet seed layer 14 by other conventional means, such as by applying a fluid precursor pattern eg by screen printing or decal or transfer application, which is then converted to the desired solid conductor pattern 18. However, electroplated conductor patterns 18 are generally and advantageously denser and have better strength properties, primarily due to the increased cohesiveness of the layer so applied, compared with eg screen printed conductor patterns 18.

In a process modification, high definition tracks are produced by masking and plating, followed by a repeat of these steps to produce broader tracks or areas for connections eg by substrate through holes.

In the second (Figure 3b) present embodiment the desired plating pattern is already provided by the seed layer 14 pattern, and therefore does not require the foregoing resist processing steps, that is, the seed layer 14 shown in Figure 3b may be plated directly, or (less usually) the conductor pattern may be applied as above.

The result of the plating process (or other process for applying the conductor patter 18) and any necessary removal of a resist is that (as shown in Figures 5 and 6) a thick conductor patter 18 is built up on a thin seed layer 14, respectively as a continuous sheet or in a pattern corresponding to the conductor pattern.

In the first embodiment of the invention the seed layer 14 surface not covered by and adhering to the conductor pattern 18 is then attacked with an appropriate solvent for the seed layer metal, such as in the case of gold, potassium iodide/iodine solution, Superstrip 100 (Lea Ronal) or Entreat 100 (Engelhard) to remove all of the continuous seed layer not covered by the conductor pattern 18, resulting in essentially the same product as that of the direct plating product of the second embodiment.

It will be appreciated that, in an alternative, gold tracks may be plated onto a gold seed layer. The skilled man will appreciate that the first embodiment of the process may still be used, but that it will be necessary to protect the gold tracks 18 conventionally in any removal of the gold seed layer 14 as described immediately above.

In one modification of the described method, shown in Figure 7, the copper pattern 18 is coated with an antioxidation film 24 analogous to the film 9 on the conductor pattern 8 on the first substrate 2 and present for the same reasons. In yet a further modification, the film 24 is coated with a thin film of copper as an adhesion promotor to the next layer of fired dielectric applied.

In a further modification of the described method (not shown), the seed layer is applied in a pattern of (usually rectangular) windows in an otherwise generally continuous layer.

A thick film resistor compositions is then conventionally applied across each window (eg by screen printing) to overlap the seed layer at a pair of opposing sides and is fired to form a resistor. The conductor tracks 18 are then applied as described hereinbefore. The skilled man will appreciate that it may be necessary to protect the resistor conventionally during any such plating process. This modification gives improved track terminals to the resistors.

Test Examples

Copper conductors in a single layer circuit were laid down as described above on seed layers applied by the process of the present invention on dielectric layers (c. 15 micron thick after firing) applied directly to 96% pure alumina, using the following combinations of dielectric and seed layer compositions:

|     | Dielectric | Seed Layer |
| --- | --- | --- |
| (1) | Du Pont 5032 | Engelhard TX18001X |
| (2) | Du Pont 5032 | Heraeus 20003 |
| (3) | Du Pont 5704 | Engelhard TX18001X |
| (4) | Du Pont 9950 | Engelhard TX18001X |
| (5) | Du Pont 9950 | Heraeus 20003 |
| (6) | EMCA 8006 | Heraeus 20003 |
| (7) | EMCA 8006 | Engelhard TX18001X |

The conductors were subjected to a modified version of the pull peel test method described in the DuPont bulletin A-74672.

The modification used was to dip solder the 2mm x 2mm copper pads described in the bulletin and to hand solder individual wires to each pad, rather than to rows of pads. The conductors were tested as formed initially and after accelerated aging at 150°C for 1000hr and at 165°C for 500 hr.

In the case of aging at 150°C, the wires were soldered to the pads before aging; at 165°C the conductors were aged, mechanically cleaned, and then the wires were soldered to the pads. The following results were obtained, fracture occurring mainly in the dielectric.

|             | Yield stress average values, kg, | | |
| --- | --- | --- | --- |
| Composition | Initial | 1000 hr 150°C | 500 hr 165°C |
| (1) | 3.8 | 3.3 | 4.5 |
| (2) | 3.8 | 2.1 | 3.7 |
| (3) | 2.7 | 2.6 | 3.3 |
| (4) | 2.5 | 2.8 | 3.0 |
| (5) | 3.9 | 2.1 | 3.8 |
| (6) | 2.8 | 2.1 | 4.0 |
| (7) | 3.2 | 2.8 | 3.8 |

All values were found to be substantially better than corresponding values for the same compositions applied conventionally. After heat aging for 1000 hours at 150°C all bonds were at least 50% of the original bond strength.

EP 0 394 977 A2

The first substrate to which the dielectric composition is applied in the process of the present invention may suitably be a ceramic, a glass or a glass-ceramic material which softens at a temperature substantially high than any firing temperature of the dielectric and seed layer compositions or of any fired component subsequently applied (eg an air-fired resistor).

Where the substrate is a ceramic it is preferably one selected from the group consisting of beryllia, alumina, zirconia, silica, aluminium nitride, silicon carbide, silicon nitride, strontium nitride, barium titanate, barium tetratitanate and barium zircotitanate.

Suitable glasses include respectively high-melting barium and lead borosilicate and aluminosilicate and other barium glasses and high-melting glass containing dissolved metal oxides.

Suitable glass-ceramics include silicate glasses containing dispersed particulate ceramics. Suitable such ceramics include metal oxides, such as beryllia, alumina and zirconia, and silica, aluminium nitride, silicon carbide, silicon nitride, strontium nitride and barium (zirco) titanate.

The substrate may also suitably be a coating of one or more such materials on a ceramic sheet, for example to a thickness in the range of 1 to 500 micron. Suitable sheet ceramics include those ceramics listed above. Other mixtures of all the foregoing materials may be used.

The substrate may also suitably be a coating of one or more such materials on a metal sheet, for example to a thickness in the range of 1 to 500 micron. Suitable sheet metals include iron, cobalt, nickel, titanium and copper and alloys thereof, including stainless steels and low carbon steels.

Where the organometallic compound in the seed layer composition is of the preferred (low decomposition temperature) type described below, and all the other components have a similarly low decomposition temperature, the substrate may be a low melting glass, such as a soda glass.

The substrates for use in the invention may have any suitable form, and may have a wide variety of shapes and sizes. For example, they may be of the form described above in the specific description of the seed layer production process.

The dielectric compositions used in the process of the present invention may be entirely conventional. The dielectric composition will be one capable of firing in the same ambient medium as the seed layer compositions, generally and advantageously air, since this increases the range of usable dielectrics and the density of the fused product. When such compositions are fired on a substrate surface in the process of the present invention as described hereinbefore, they each produce a fused dielectric layer which has especially good long-term adhesion to the seed layer on it.

Compositions of the components named herein have especially good properties of this type and, when fired on the appropriate substrates named herein, also have good adhesion to the latter.

The dielectric to which the present seed layer composition is applied may suitably be a glass or a glass-ceramic material which fuses at a temperature lower than the softening or melting temperature of the first substrate to which it is applied, but once fused subsequently only softens at a temperature higher than the firing temperature of any fired component subsequently applied (eg an air-firing dielectric, which may form a third substrate for a third circuit layer). Devitrifying glasses and glass-ceramics are thus favoured.

Suitable glasses include respectively medium-melting barium and lead borosilicate and aluminosilicate and other barium glasses and medium-melting glass containing dissolved metal oxides. Suitable glass-ceramics include silicate glasses containing dispersed particulate ceramics. Suitable such ceramics include metal oxides, such as beryllia, alumina and zirconia, and silica, aluminium nitride, silicon carbide, silicon nitride, strontium nitride and barium (zirco)titanate.

Mixtures of all the foregoing materials may be used.

Where the organometallic compound in the seed layer composition is of the preferred (low decomposition temperature) type described below, and all the other process components have a similarly low decomposition temperature, the dielectric may be a low melting glass, such as a soda glass,

The dielectric composition will generally comprise the dielectric as a particulate dispersion in a fluid vehicle.

In addition to the dielectric and vehicle, the composition will generally comprise a resin, polymer, or other thickener or thixotrope ('viscosifier') chosen for its ability (together with the vehicle) to confer a viscosity (in a manner known to the skilled man) on the composition which is suitable for application to the substrate in a desired (retained) pattern, as described further above, and to bind the dielectric in the dried dielectric layer. Suitable viscosifier materials include cellulose derivatives, such as ethyl cellulose, cellulose acetate butyrate and nitrocellulose, Perchem XT (Perchem) and Thixatrol SR (NL Industries), and most of the resins and polymers mentioned hereinafter in relation to the seed layer composition.

The composition may also contain other conventional additives, eg plasticisers, such as dioctyl phthalate (generally at up to 10% w/w); and flow aids, such as silicone oils ad acrylics (eg Modaflow, Multiflow [Monsanto]), generally at up to 5% w/w.

7

The rheological parameters of the composition will (in addition to varying with the viscosifier) also vary in a manner evident to the skilled man with the amount of any fluid vehicle which is present. The vehicle will often be a mixture of organic liquids.

Any such vehicle will often be chemically inert, and should preferably of low toxicity. A fairly high boiling point or mixture of boiling points will tend to be desirable.

The vehicle boiling point is significant in controlling the necessary removal of the vehicle from the composition on a substrate during any drying before firing or in the early stages of any firing process. Boiling points in the range 150 to 250° C are preferred. It is often desirable that the viscosifier is at least partially soluble in the vehicle.

Suitable vehicles include the following and compatible mixtures thereof:

aromatics, such as nitrobenzene, o-nitrotoluene and xylene, and high-boiling petroleum fractions, eg Aromasol H;

aliphatics and essential oils;

alcohols, including terpene alcohols (such as $\alpha$-terpineol, $\alpha,\beta$-terpineol and $\alpha,\beta,\gamma$-terpineol), butyl carbitol and Cellosolve;

esters, such as butyl carbitol acetate, butyl oxalate, dibutyl phthalate, dibutyl benzoate, Texanol ester and butyl Cellosolve acetate;

and others such as colophony.

Preferred vehicles or vehicle components include $\alpha$-terpineol, $\alpha\beta$-terpineol and $\alpha,\beta,\gamma$-terpineol, butyl carbitol, butyl carbitol acetate and Texanol ester.

Examples of unfavoured but sometimes necessary low-boiling low molecular weight vehicle components include chlorinated aliphatic solvents, ketones, esters, alcohols, aromatics and petroleum ethers.

In the dielectric compostions used in the process of the present invention the proportions of dielectic to viscosifier to vehicle may vary, and may be optimised by routine trial to give desired physical propeties of the composition.

The proportion of the dielectric in the composition may be 30 to 90%, eg 65 to 80% w/w. The proportion of the viscosifier may be 1 to 75%, preferably 5 to 20% w/w, and that of the vehicle up to 50% w/w, preferably 10 to 35% w/w.

Examples of suitable dielectric compositions include:

conventional air-firing dielectrics, such as

EMCA 9121DB, EMCA 8125, EMCA C8003, EMCA C8006, EMCA 2828DB,

Du Pont 5032, Du Pont 9950, Du Pont 5704, Du Pont 9429,

ESL 4901, ESL 4905, ESL 4612, ESL D4910,

Heraeus IP9117,

Remex 7006, Remex 7007, Remex 7008, Remex 7009, Remex 7010, Remex 7260,

Engelhard HD2011, and

Ferro DF10-016;

nitrogen-firing dielectrics, such as

EMCA C8002,

Du Pont 4575, Du Pont 5681, Du Pont 4275,

ESL 4906,

Heraeus IP7116, Heraeus IP9241,

Remex 1902, Remex 1903,

overglazes, such as

EMCA 8503, EMCA 2274, EMCA 99G,

Du Pont 9137, Du Pont 5137, Du Pont 9537,

ESL 4026, ESL 4027,

Heraeus 9021, Heraeus IP124, Heraeus 9028

Remex 1907, Remex 7500 series,

low temperature dielectrics, such as

EMCA 9041-1, EMCA 6310, EMCA 2084, EMCA 2084W, EMCA 1680, EMCA 1678,

Du Pont 7701, Du Pont 4480,

ESL M4030, ESL M4032, ESL 4023B, ESL 4028B,

and

dielectrics for aluminium nitride, such as

Ferro DP10-007.

The seed layer compositions used in the process of the present invention may be entirely conventional. When such compositions are fired on a dielectric composition layer in the process of the present invention as described hereinbefore, such compositions each produce a seed layer which has especially good long-term adhesion to the fused dielectric layer under it.

Compositions in which all the components (including the usual organometal compound, resin or polymer and vehicle) are mutually soluble tend to have advantageous homogeneity, giving rise to seed layers with the enhanced desired physical properties.

The exact nature of the organometallic compound within the present coating composition is immaterial, provided

a) it is of a metal which is suitable for forming a seed layer between a substrate of the type described hereinbefore and a conductor track of a metal conventionally used for such circuit tracks, and

b) it fulfils the compatibility criteria also laid down hereinbefore.

The metal which is used for such tracks is selected for compatibility with eg any futher dielectric layers, and preferably, the metal is one which can be deposited by electroplating.

Suitable metals include copper, palladium, gold, platinum and nickel, in particular copper and gold. Alloys of all the foregoing materials may be used.

Suitable seed layer metals for the foregoing track metals include gold, rhodium, platinum, palladium, silver and alloys thereof. In the case of copper tracks, favoured seed layer metals include gold and silver, in particular gold.

One suitable class of organometallic compounds in the seed layer composition is that in which a metallic moiety is bound (generally via a thio or polythio bridge) to a hydrocarbon moiety, the so-called metal resinates (eg the reaction product of the relevant metal chloride and a rosin or terpene sulphide, or of the relevant metal oxide with rosin). Preferably the hydrocarbon moiety is fairly large, eg a $C_{8-40}$ hydrocarbon, such as a $C_{8-16}$ hydrocarbon.

For copper or gold tracks, a preferred class of seed layer organometallic compounds includes organogold compounds. These will now be discussed in greater detail, but the skilled man will appreciate that similar considerations will apply to other metal resinates.

Examples of gold resinates comprise terpene sulphides, including gold dipentene sulphide, and in particular gold sulphides of (poly)cyclic terpenes, such as gold $\alpha$-pinene sulphide, gold $\beta$-pinene sulphide, gold terpinolene sulphide, gold menthene sulphide, gold camphene sulphide and gold $\Delta^3$-carene sulphide. Examples of suitable seed layer compositions containing such gold resinates include Engelhard 6552 and TX18001X, and Heraeus 20003.

This class of compounds also includes the gold mercaptides of $\alpha$-thioterpineol, $\beta$-thioterpineol and thioborneol.

It will also similarly be seen that another suitable class comprises alkyl mercaptides of gold, in particular where the gold is on a secondary or tertiary carbon atom, eg gold tert-dodecyl mercaptide.

The metal compound suitably has a decomposition temperature in any medium in the range of 100 to 550°C, favourably in the range of 150 to 350°C. ('Decomposition temperature' herein means the point of a relevant TGA trace at which 90% weight loss of the total organics in the material has occurred, all such TGA traces being determined under as near identical conditions as possible.) It will be appreciated that the relevant decomposition temperatures will mainly be those determined in air, since the present compositions are mainly provided for air-firing application.

However, firing of the compositions and substrate may in some instances be carried out in an inert atmosphere such as nitrogen, where the decomposition temperature will tend to be higher than in air.

In one class of organometallic compounds, each will have a thermal decomposition temperature of 100 to 400°C, favourably in the range of 150 to 350°C, favourably at least 200°C below that of the resin or polymer which is generally also present in the composition, and preferably at least 250°C below.

The seed layer composition used within the process of the present invention will also generally comprise a resin or polymer. Included within the scope of the term 'polymer' are all types of homo- and co-polymers and oligomers. The resin or polymer will seldom be a pure compound, but will often consist of a molecular weight cut of a mixture of congeners.

The resin or polymer will be used inter alia (together with the vehicle) to confer a viscosity (in a manner known to the skilled man) on the composition which is suitable for application to the dielectric layer in a desired (retained) pattern, as described further above.

The seed layer composition when applied by screen printing will suitably have a viscosity in the range of 20 to 2000 ps, preferably 200 to 1000 ps, at 2.5 rpm.

Materials which may be used include rosin, colophony and asphalt (Gilsonite), and synthetic resins, such as thermosetting epoxy resins (eg the reaction product of epichlorohydrin and bisphenol A, together with curing agents) and acrylic resins. Other materials include cellulose derivatives, such as ethyl cellulose, cellulose acetate butyrate, nitrocellulose, Perchem Xl (Perchem) and Thixatrol ST (NL Industries).

The resin or polymer may suitably have a decompostion temperature in any medium in the range of 150 to 1000° C, favourably in the range of 400 to 550° C.

Favoured polymers include those of dienes, such as butadiene, 1,5-cyclooctadiene and mixtures thereof, optionally with vinylics such as styrene and/or acrylics.

Poly(butadienes) and butadiene - styrene copolymers, such as the Cariflex series (Shell) are amongst preferred polymers.

Another suitable class of polymers include polyaromatics such as polyphenylene and PES, PEK and PEEK (ICI).

The foregoing resins and polymers belong to known classes of materials.

Most of the resins and polymers mentioned hereinbefore may be used alone as composition component or as mixtures.

The rheological parameters of the composition will (in addition to varying with the resin or polymer) also vary in a manner evident to the skilled man with the amount of a vehicle. Suitable and favoured vehicles are those mentioned for the dielectric composition hereinbefore, and for the same reasons.

Preferred vehicles or vehicle components include α-terpineol, butyl carbitol and Aromasol H.

The proportions of the metal compound in the composition may be 20 to 50, eg 25 to 30% w/w. Typically the compound will contain the metal at 35 to 55%, eg 45 to 55% w/w.

The proportion of resin or polymer may be 1 to 95%, preferably 1 to 55% w/w, and that of the vehicle up to 50% w/w.

The present composition may contain other conventional components, such as;

traces of organometallic compounds (including resinates) of other metals eg to improve the finish of the seed layer, (which are included, in the case of a gold seed layer composition in the so-called gold fluxes), such as

bismuth flux (eg the reaction product of bismuth subnitrate and rosin), generally at up to 7% w/w, and rhodium flux or resinate (eg the reaction product of rhodium chloride and terpene sulphide) generally at up to 2% w/w,

chromium flux (e.g. as a diketonate complex), generally at up to 2% w/w,

lead, cadmium, tin, copper, cobalt, antimony, and vanadium fluxes (eg the reaction product of the relevant metal oxide with rosin), and silicon fluxes, each generally at up to 1% w/w,

in the case of a composition for a seed layer other than gold (such as silver), an organogold compound eg of the types described above,

generally at up to 2% w/w, and

anti-tack additives (generally at 10% w/w); flow aids (generally at up to 5% w/w); and visualisation aids (generally at up to 0.1% w/w).

One class of seed layer compositions each comprise an organogold compound and an organosilver compound present as 0.5 to 10 parts by weight silver per 100 parts by weight per 100 parts gold, but typically at less than 6 parts by weight.

In such compositions suitable, favoured, preferred and particular components (including the silver compound) and their proportions are as so described hereinbefore for the generality of seed layer compositions.

The silver compound will generally be present as 0.025 to 0.5% w/w. Typically it will be present at less than 0.3% w/w.


## Claims

1. A process for producing a metal seed layer on a first substrate selected from the group consisting of ceramic, glass or glass-ceramic substrates or a metal sheet coated with a ceramic, glass or glass-ceramic material, characterized in that the process comprises

a) applying to a least a portion of the first substrate a first layer of a fluid composition comprising a dielectric which when fired is capable of forming an inorganic dielectric layer by decomposing and vaporising and organic constituents therein, and

b) applying to at least a portion of the first layer on the surface of the first substrate a second fluid composition comprising an organometallic compound of a desired seed layer metal, said second fluid composition when fired being capable of forming a metal seed layer layer by decomposing and vaporising the organic portion of said composition, and

c) firing said first layer and said second layer together forming a second substrate layer on the first substrate and a metal seed layer on the surface of the second substrate layer.

2. The process of claim 1 wherein the first fluid composition comprising a dielectric is dried so that it is no longer fluid when the fluid composition comprising an organometallic compound is applied.

3. The process of claim 1 wherein the first substrate bears a layer of circuit components and the second substrate is applied to cover at least some of the components.

4. The process of claim 3 wherein the circuit components include metal conductor pattern.

5. The process of claim 4 wherein the dielectric composition forming the second substrate layer is 15 to 60 microns thick after firing.

6. The process of claim 5 wherein the dielectric composition is laid down in a plurality of coating layers.

7. The process of one or more of claims 1 to 6 characterised in that prior to step a) the first substrate is provided with one or more fired and fused layers.

8. The process of claim 1 wherein the metal seed layer is applied as a continuous layer covering the dielectric layer.

9. The process of claim 7 wherein at least a portion of the metal seed layer is electroplated or electrolessly plated with metal.

10. The process of claim 9 wherein a portion of the metal seed layer is covered with a resist which outlines a conductor pattern, and exposed portion of the metal seed layer is electroplated or electrolessly plated.

11. The process of claim 1 wherein the metal seed is laid down generally corresponding to a final conductor pattern.

12. The process of claim 11 wherein the metal seed layer pattern further includes extra areas to provide electrical continuity, and the conductor pattern is formed by electroplating.

13. The process of claim 1 wherein the dielectric composition fuses at a temperature lower that the softening or melting temperature of the first substrate, and once fused subsequently only softens at a temperature higher than the firing temperature of any subsequently applied and fired component.

14. The process of claim 13 wherein the dielectric composition comprises a particulate dispersion in a fluid vehicle, and the particulates are selected from the group consisting of glasses and glass-ceramics and mixtures thereof.

15. The process of claim 1 wherein the seed layer metal is selected from the group consisting of gold rhodium, platinum, palladium, silver and alloys thereof.

16. The process of claim 15 wherein the seed layer metal is gold containing 0.5 to 10 parts by weight silver per 100 parts by weight gold.

17. The process of claim 15 wherein the metal seed layer contains 0.1 to 2 $mg/cm^2$ of metal.

18. The process of claim 1 wherein the fluid composition containing an organometallic compound of a desired seed layer metal further contains fluxes selected from the group of resinates and organic complexes of bismuth, rhodium, chromium, lead, cadmium, tin, copper cobalt, antimony and vanadium.

19. A metallised ceramic article having adhesion of the metallic coating to the ceramic substrate superior to conventional metallised ceramics, said article being produced by the processes of any of claims 1 to 18.

20. A metallised ceramic article produced by the processes of any of claims 1 to 18, the adhesive peel strength of metallic layer to the ceramic substrate being capable of being maintained at least 50% of the original strength after heat aging for 1000 hours at 150° C.

*Fig.1a.*

*Fig.1b.*

*Fig.2.*

*Fig.3a.*

*Fig.3b.*

*Fig.4.*

*Fig.5.*

*Fig.6.*

*Fig.7.*